# EUROPEAN PATENT SPECIFICATION

(11) **EP 2 806 569 B1**
(45) Date of publication and mention of the grant of the patent: **27.04.2016**
(21) Application number: 14168558.6
(22) Date of filing: 16.05.2014
(51) Int. Cl.: H04B 1/18, G01R 31/02, G01R 31/04

(54) **Load-connection-state detection circuit**
Lastverbindungszustands-Detektionsschaltung
Circuit de détection de l'état de connexion de charge

(30) Priority: 24.05.2013 JP 2013109780
(43) Date of publication of application: 26.11.2014
(73) Proprietor: Alps Electric Co., Ltd., Tokyo 145-8501 (JP)
(72) Inventor: Maruyama, Takashi, Tokyo 145-8501 (JP)
(74) Representative: Klunker . Schmitt-Nilson . Hirsch

(56) References cited:
- JP-A- 2010 081 693
- JP-A- 2012 191 381
- JP-A- 2012 222 885

## Description

The present invention relates to a load-connection-state detection circuit which is connected to a load circuit and which detects the connection state of the load circuit, and particularly to a load-connection-state detection circuit having a current limiting circuit.

In receivers used in, for example, global positioning system (GPS) apparatuses mounted in vehicles or the like, it is important that a load circuit is satisfactorily connected to receive incoming radio waves optimally. To detect the connection state of a load circuit, a load-connection-state detection circuit which detects whether or not the connection state of the load circuit is satisfactory may be installed in a receiver. A known load-connection-state detection circuit performs current limiting by turning off a switching element when the impedance of the load circuit is smaller than a predetermined value (for example, see Japanese Unexamined Patent Application Publication No. 2012-191381). A state in which a load circuit is satisfactorily connected refers to a state in which the impedance of a load circuit seen from the load-connection-state detection circuit is within a range of an appropriate impedance.

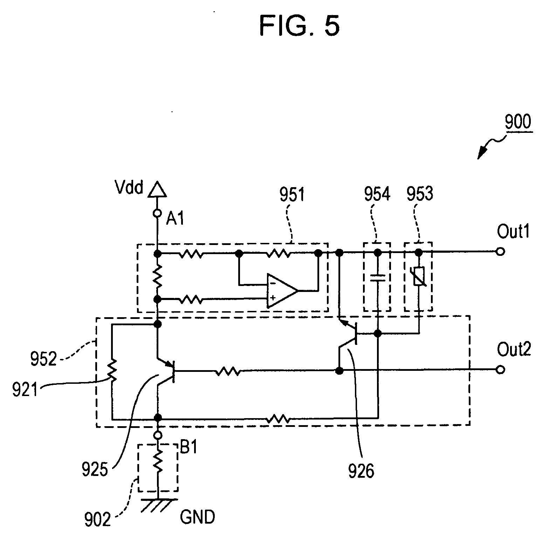

Fig. 5 illustrates a load-connection-state detection circuit 900 as a first related art example described in Japanese Unexamined Patent Application Publication No. 2012-191381.

As illustrated in Fig. 5, the load-connection-state detection circuit 900 includes an antenna detecting circuit 951, a current limiting circuit 952, a temperature compensating circuit 953, and a potential holding circuit 954. The load-connection-state detection circuit 900 includes a power terminal A1 supplied with a power supply voltage Vdd, and a connector B1 connected to an antenna 902. The load-connection-state detection circuit 900 also includes a first output terminal Out1 and a second output terminal Out2 for transmitting detection results of the connection state of the antenna 902 to the outside.

In the load-connection-state detection circuit 900, a transistor 925 and a resistance 921 are connected in parallel to each other. When the impedance of the antenna 902 is equal to or larger than a predetermined value, the transistor 926 is turned on, and the transistor 925 is also turned on. In contrast, when the impedance of the antenna 902 is equal to or smaller than the predetermined value, the transistor 926 is turned off, and the transistor 925 is also turned off. Therefore, when the impedance of the antenna 902 is smaller than the predetermined value, instead of passing a current through the transistor 925, a current can flow through the resistance 921. That is, a current flowing through the transistor 925 can be limited. Accordingly, damage of the transistor 925 caused by a large current can be prevented.

As described above, when the impedance of the antenna 902 is smaller than the predetermined value, the load-connection-state detection circuit 900 performs current limiting on the transistor 925. Therefore, damage of the transistor 925 caused by a large current can be prevented. However, in a vehicle-mounted circuit such as the load-connection-state detection circuit 900, external power such as a car battery may be accidentally connected to the connector B1 connected to the antenna 902. In such a case, an excessive current flowing from a car battery may cause damage of semiconductor devices in the load-connection-state detection circuit 900 or damage of semiconductor devices in a power supplying circuit (not illustrated) for stabling the voltage of the power from the car battery.

To address such a problem, electronic equipment as described in JP 2012-222885 A has been proposed. Electronic equipment 804 as a second related art example described in JP 2012-222885 A is illustrated in Fig. 6.

In a protection circuit 801 in the electronic equipment 804, when a direct-current power supply 821 is satisfactorily connected, that is, when the positive electrode + of the direct-current power supply 821 is connected to a direct-current power supply line B and the negative electrode - of the direct-current power supply 821 is connected to a ground power supply line GND, a P channel FET 803a is turned on. The P channel FET 803a supplies power between a first node ND1 and a second node ND2. Therefore, an electronic circuit 804a operates normally by using the direct-current power supply 821.

In contrast, when the direct-current power supply 821 is connected the other way around, that is, when the positive electrode + of the direct-current power supply 821 is connected to the ground power supply line GND and the negative electrode - of the direct-current power supply 821 is connected to the direct-current power supply line B, the P channel FET 803a is turned off. The P channel FET 803a interrupts power between the first node ND1 and the second node ND2, enabling the electronic circuit 804a to be protected from the reverse connection.

However, in the electronic equipment 804, the protection circuit 801 constituted by multiple elements needs to be disposed between the direct-current power supply line B and the electronic circuit 804a and between the ground power supply line GND and the electronic circuit 804a. As a result, the circuit size of the electronic equipment 804 is increased, and a large number of parts need to form the protection circuit 801, causing the cost of the electronic equipment 804 to be increased.

To provide a circuit substituted for the protection circuit 801 described above, a diode for preventing reverse connection may be disposed between a terminal T1 and the electronic circuit 804a. In this case, since the number of parts is only one, the circuit size is not increased and the cost of the electronic equipment 804 is not markedly increased. However, when a diode is disposed between the terminal T1 and the electronic circuit 804a, the voltage is decreased by the forward voltage of the diode, and a power supply voltage obtained through voltage drop is supplied from the direct-current power supply 821 to the electronic circuit 804a. As a result, a voltage range used by the electronic circuit 804a is narrowed, causing the circuit performance of the electronic circuit 804a to be affected.

In view of these problems of the related art, the present invention providers a load-connection-state detection circuit, as defined in claim 1, which can perform current limiting and which can protect semiconductor devices in the circuit even when an abnormal voltage higher than a power supply voltage is applied to a connector, without increasing the circuit size.

To solve these problems, there is provided a load-connection-state detection circuit including a power terminal, a connector, and a current limiting circuit. The power terminal is supplied with power from the outside. The connector supplies power to a load circuit connected to the ground. The current limiting circuit includes a PNP first transistor having an emitter connected to the power terminal and having a collector connected to the connector, an NPN second transistor having an emitter connected to the power terminal, having a collector connected to a base of the first transistor, and having a base connected to the collector of the first transistor, and a first resistance connected between the emitter and the collector of the first transistor, in such a manner that a current flows via the first resistance when a current is limited. The load-connection-state detection circuit further includes a switching element having a control end, one end of the switching element is connected to the base of the second transistor, the other end of the switching element is connected to the ground, and the control end is connected to the collector of the second transistor.

The load-connection-state detection circuit having the above-described configuration can perform current limiting and can turn off the first transistor and the second transistor when an abnormal voltage higher than a power supply voltage is applied to a connector, by adding one switching element. As a result, a current caused by the abnormal voltage applied to the connector flows through the first resistance connected between the emitter and the collector of the first transistor, enabling the semiconductor devices in the circuit to be protected. Therefore, a load-connection-state detection circuit which can protect the semiconductor devices in the circuit even when an abnormal voltage is applied to the connector is achieved without increasing the circuit size.

In the load-connection-state detection circuit having the above-described configuration, preferably the switching element which is a field effect transistor has a drain connected to the base of the second transistor and also has a source connected to the ground.

The load-connection-state detection circuit having the above-described configuration uses a field effect transistor as a switching element, enabling the switching operation to be easily performed.

In the above-described configuration, the load-connection-state detection circuit may further include a second resistance and a comparator. The second resistance has one end connected to the power terminal and has the other end connected to the emitter of the first transistor. The comparator has an inverting input terminal connected to one end of the second resistance via a third resistance and has a non-inverting input terminal connected to the other end of the second resistance via a fourth resistance. A fifth resistance is connected between the inverting input terminal and an output end. A connection state of the load circuit is detected from an output voltage from the comparator and from a voltage of the collector of the second transistor.

The load-connection-state detection circuit having the above-described configuration can easily detect the connection state of the load circuit connected to the connector by checking the output voltage of the comparator and the voltage of the collector of the second transistor.

In the load-connection-state detection circuit having the above-described configuration, the load circuit may include a cable and an amplifying circuit.

The load-connection-state detection circuit having the above-described configuration can easily detect the state, such as the cutoff or short-circuit of the cable connected to the connector or a failure of the amplifying circuit.

The load-connection-state detection circuit in the present invention can perform current limiting and can turn off the first transistor and the second transistor when an abnormal voltage higher than a power supply voltage is applied to a connector, by adding one switching element. As a result, a current caused by the abnormal voltage applied to the connector flows through the first resistance connected between the emitter and the collector of the first transistor, enabling the semiconductor devices in the circuit to be protected. Therefore, a load-connection-state detection circuit which can protect the semiconductor devices in the circuit even when an abnormal voltage is applied to the connector is achieved without increasing the circuit size.

### BRIEF DESCRIPTION OF THE DRAWINGS

Fig. 1 is a block diagram illustrating the connection relationship between a load-connection-state detection circuit and a load circuit according to an embodiment of the present invention;
Fig. 2 is a circuit diagram of the load-connection-state detection circuit according to an embodiment of the present invention;
Fig. 3 is a diagram illustrating a table for the load-connection-state detection circuit which describes the states of transistors, a FET, a first output terminal, and a second output terminal at the time when current limiting is performed, according to an embodiment of the present invention;
Fig. 4 is a diagram illustrating a table for the load-connection-state detection circuit which describes the states of the transistors and the FET at the time when an abnormal voltage higher than a power supply voltage is applied to a connector, according to an embodiment of the present invention;
Fig. 5 is a circuit diagram of a load-connection-state detection circuit according to a first related art example; and

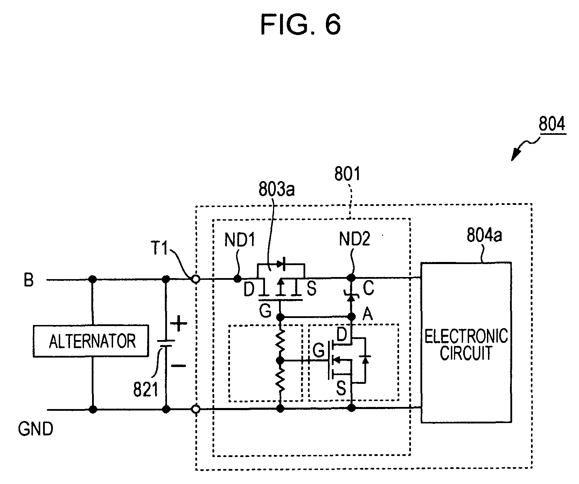

Fig. 6 is a circuit diagram of a load-connection-state detection circuit according to a second related art example.

An embodiment of the present invention will be described below with reference to the drawings.

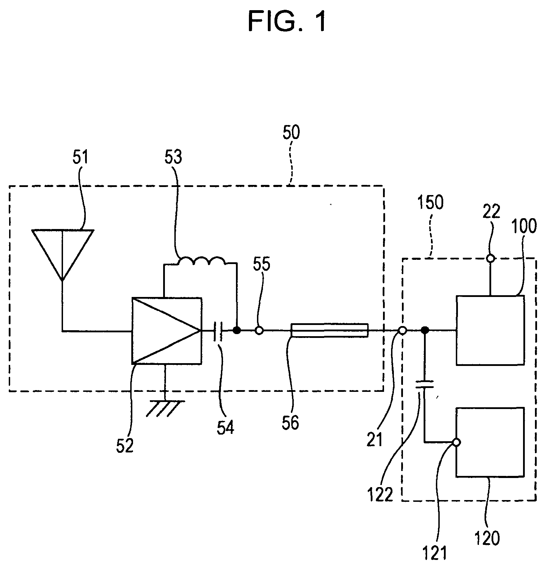

Fig. 1 is a block diagram illustrating the connection relationship between a load-connection-state detection circuit 100 and a load circuit 50 according to the embodiment of the present invention.

As illustrated in Fig. 1, the load-connection-state detection circuit 100 according to the embodiment of the present invention is included in a GPS receiver 150 mounted in a vehicle or the like. The GPS receiver 150 includes a GPS receiving circuit 120 as well as the load-connection-state detection circuit 100, and performs various types of processing for GPS reception. The load-connection-state detection circuit 100 connected to a power terminal 22 supplies power to the load circuit 50. A high-frequency-signal input terminal 121 of the GPS receiving circuit 120 is connected to a connector 21 of the load-connection-state detection circuit 100, and the high-frequency-signal input terminal 121 receives a high frequency signal from the load circuit 50. A capacitor 122 for cutting a direct current is connected between the connector 21 and the high-frequency-signal input terminal 121.

As illustrated in Fig. 1, the load circuit 50 includes an antenna 51, an amplifying circuit 52, an inductor 53, a capacitor 54, a high-frequency-signal output terminal 55, and a cable 56. The cable 56 which connects the GPS receiver 150 to the amplifying circuit 52 plays a role of supplying power from the load-connection-state detection circuit 100 to the amplifying circuit 52, as well as of transmitting a high frequency signal received at the antenna 51 to the GPS receiver 150. The antenna 51 receives an incoming GPS signal and transmits it to the amplifying circuit 52. The amplifying circuit 52 amplifies the received GPS signal which is transmitted from the high-frequency-signal output terminal 55 via the cable 56 to the high-frequency-signal input terminal 121 of the GPS receiving circuit 120. A power terminal in the amplifying circuit 52 is connected to the cable 56 via the inductor 53 so that a high frequency signal which is output from the amplifying circuit 52 is not affected. An output terminal of the amplifying circuit 52 for a high frequency signal is connected to the cable 56 via the capacitor 54 so that a direct current does not flow from the load-connection-state detection circuit 100.

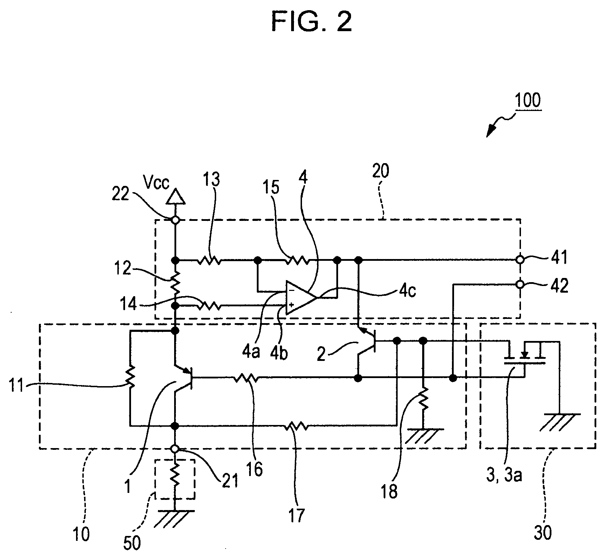

The circuit configuration of the load-connection-state detection circuit 100 will be described. Fig. 2 is a circuit diagram of the load-connection-state detection circuit 100 according to the embodiment of the present invention. As illustrated in Fig. 2, the load-connection-state detection circuit 100 is constituted by a current limiting circuit 10, a load-connection-state determination circuit 20, and a switching circuit 30.

The current limiting circuit 10 includes a first transistor 1 and a second transistor 2. The current limiting circuit 10 also includes a first resistance 11, a sixth resistance 16, a seventh resistance 17, and an eighth resistance 18 to connect between the transistors or between each transistor and the power terminal 22 or the connector 21. As described above, the load circuit 50 is connected to the connector 21. The power terminal 22 is supplied with a power supply voltage Vcc obtained, for example, by lowering the voltage of a battery (not illustrated) of a vehicle through a regulator (not illustrated), from the outside. The load-connection-state detection circuit 100 according to the embodiment of the present invention has a Vcc of 5 V.

The first transistor 1 is a PNP bipolar transistor. The emitter of the first transistor 1 is connected to the power terminal 22 via a second resistance 12, and the collector is connected to the connector 21. The first resistance 11 is connected between the emitter and the collector of the first transistor 1. In the case where the first transistor 1 is turned off when current limiting is performed, the current limiting circuit 10 causes a current to flow through the first resistance 11. The resistance value of the first resistance 11 may be, for example, 10 kΩ.

The second transistor 2 which is an NPN bipolar transistor has a base connected to one end of the eighth resistance 18 in which the other end is connected to the ground, and a collector connected to the base of the first transistor 1 via the sixth resistance 16. The base of the second transistor 2 is connected to the collector of the first transistor 1 through the seventh resistance 17.

The load-connection-state determination circuit 20 is capable of detecting the state of the load circuit 50 connected to the connector 21. Specifically, the load-connection-state determination circuit 20 includes the second resistance 12, a comparator 4, a third resistance 13, a fourth resistance 14, and a fifth resistance 15. The load-connection-state determination circuit 20 is provided with a first output terminal 41 and a second output terminal 42 for determining the load connection state.

In the load-connection-state determination circuit 20, one end of the second resistance 12 is connected to the power terminal 22, and the other end is connected to the emitter of the first transistor 1. An inverting input terminal 4a (-) of the comparator 4 is connected to one end of the second resistance 12 via the third resistance 13, and a non-inverting input terminal 4b (+) is connected to the other end of the second resistance 12 via the fourth resistance 14. The fifth resistance 15 functioning as a feedback resistor is connected between the inverting input terminal 4a (-) and a comparator output terminal 4c. The first output terminal 41 is connected to the comparator output terminal 4c of the comparator 4, and the second output terminal 42 is connected to the collector of the second transistor 2 in the current limiting circuit 10.

The second resistance 12 is connected between the power terminal 22 and the first transistor 1 in a series manner to the first transistor 1. The resistance value of the second resistance 12 is set so that a current according to the connection state of the load circuit 50 flows. The load-connection-state determination circuit 20 is capable of detecting a current flowing through the second resistance 12. The second resistance 12 has a predetermined resistance value for enabling the comparator 4 to detect the state of the load circuit 50 connected to the connector 21. For example, in the case where the impedance of the load circuit 50 is in a range of 100 Ω to 5 kΩ in the normal connection state, the resistance value of the second resistance 12 may be set to 4.7 Ω.

The third resistance 13, the fourth resistance 14, and the fifth resistance 15 are resistances for adjusting the gain of the load-connection-state determination circuit 20. The resistance value of the third resistance 13 and the fourth resistance 14 may be set, for example, to 47 Ω, and the resistance value of the fifth resistance 15 may be set, for example, to 15 kΩ.

In the load-connection-state determination circuit 20 having such a configuration, when the impedance of the load circuit 50 is smaller than a threshold which is the upper limit of the appropriate range (for example, value smaller than 5 kΩ), a current flowing through the second resistance 12 is made larger than a predetermined value. Therefore, the potential difference between the inverting input terminal 4a (-) and the non-inverting input terminal 4b (+) of the comparator 4 is made larger than a predetermined value. As a result, the comparator output terminal 4c of the comparator 4, that is, the first output terminal 41 has a low potential (hereinafter, referred to as a low level).

When the impedance of the load circuit 50 is larger than a threshold (for example, a value larger than 5 kΩ), the value of a current flowing through the second resistance 12 is smaller than a predetermined value, resulting in the state in which a potential difference between the inverting input terminal 4a (-) and the non-inverting input terminal 4b (+) of the comparator 4 is smaller than the predetermined value. In this case, the comparator 4 does not operate, and the comparator output terminal 4c of the comparator 4, that is, the first output terminal 41 is supplied with a high potential (hereinafter, referred to as a high level).

The switching circuit 30 includes a field effect transistor 3a (hereinafter, referred to as a FET 3a) serving as a switching element 3. The gate of the FET 3a serving as a control terminal of the switching element 3 is connected to the collector of the second transistor 2, and the drain of the FET 3a serving as one end of the switching element 3 is connected to the base of the second transistor 2. The source of the FET 3a serving as the other end of the switching element 3 is connected to the ground.

When the gate-source voltage of the FET 3a is equal to or larger than a threshold voltage and when the voltage is sufficiently large, the FET 3a turns on. When the gate-source voltage of the FET 3a is smaller than a threshold voltage which is a sufficiently small voltage, the FET 3a turns off. Thus, the load-connection-state detection circuit 100 uses the field effect transistor 3a serving as the switching element 3, enabling the switching operation to be easily performed.

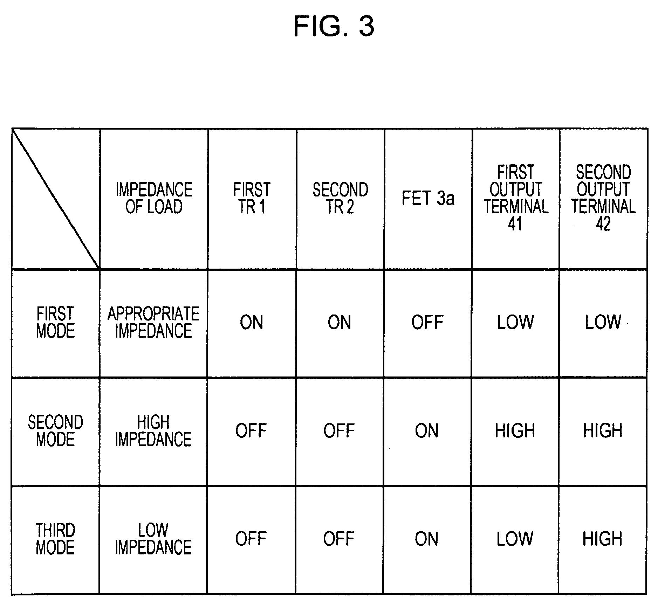

The circuit operation of the load-connection-state detection circuit 100 will be described by using Figs. 2 and 3. The circuit operation of the load-connection-state detection circuit 100 at the time when normal current limiting is performed in a state in which an abnormal voltage is not applied from the outside to the connector 21 is different from one at the time when an abnormal voltage which is higher than the power supply voltage Vcc is applied from the outside in a state in which the load circuit 50 is not connected to the connector 21. Thus, the state in which the current limiting is performed and the state in which an abnormal voltage is applied will be separately described.

A circuit operation in current limiting will be described. Fig. 3 illustrates a table describing the operation states of elements by classifying the impedance states of the load circuit 50 into modes, i.e., an appropriate impedance mode, a high impedance mode, and a low impedance mode. The operation states of elements in each mode are the on or off states of the first transistor 1, the second transistor 2, and the FET 3a. Whether the voltages of the output terminals, i.e., the first output terminal 41 and the second output terminal 42, are in the low level or in the high level is also described. The high-level voltage is one which causes the first transistor 1, the second the transistor 2, or the FET 3a to turn on when the voltage is applied to each of the bases of the transistors or the gate of the FET. The low-level voltage is one which causes the first transistor 1, the second transistor 2, or the FET 3a to turn off when the voltage is applied to each of the bases of the transistors or the gate of the FET.

In the load-connection-state detection circuit 100, the minimum and maximum values of the appropriate impedance of the load circuit 50 are set to predetermined values. According to the embodiment, the minimum value of the appropriate impedance of the load circuit 50 is set to 100 Ω, whereas the maximum value of the appropriate impedance is set to 5 kΩ. Hereinafter, the impedance of the load circuit 50 which is equal to or larger than 100 Ω and equal to or smaller than 5 kΩ refers to as the appropriate impedance; the impedance smaller than 100 Ω, the low impedance; and the impedance larger than 5 kΩ, the high impedance.

A circuit operation performed when the impedance of the load circuit 50 is the appropriate impedance, that is, in a first mode, will be described.

In the first mode, the power supply voltage Vcc is applied from the power terminal 22 via the second resistance 12 and the first resistance 11 to the connector 21, and a current flows through the load circuit 50. As described above, when the impedance of the load circuit 50 is the appropriate impedance, the potential difference between the inverting input terminal 4a (-) and the non-inverting input terminal 4b (+) of the comparator 4 is larger than the predetermined value, resulting in the state in which the comparator output terminal 4c of the comparator 4 is in the low level. Therefore, the emitter of the second transistor 2 is in the low level. A voltage is applied to the base of the second transistor 2 via the second resistance 12, the first resistance 11, and the seventh resistance 17. Therefore, the second transistor 2 is turned on. Since the second transistor 2 turns on, the base of the first transistor 1 is in the low level. Therefore, the first transistor 1 is turned on. At that time, since the gate of the FET 3a is also in the low level, the FET 3a is turned off. The levels of the first output terminal 41 and the second output terminal 42 at that time are in the low level.

As a result, in the first mode in which the impedance of the load circuit 50 is the appropriate impedance, the first transistor 1 turns on, and the power is therefore supplied from the power terminal 22 via the first transistor 1 to the load circuit 50. The circuit operation states of the load-connection-state detection circuit 100 in the first mode will be described in the first mode in Fig. 3.

A circuit operation performed when the impedance of the load circuit 50 is the high impedance, that is, in a second mode will be described. The state of the high impedance includes a state in which the connection state of the load circuit 50 is open.

In the second mode, the power supply voltage Vcc is applied from the power terminal 22 via the second resistance 12 and the first resistance 11 to the connector 21, and a current flows through the load circuit 50. When the connection state of the load circuit 50 is open, the power supply voltage Vcc is applied from the power terminal 22 via the second resistance 12 and the first resistance 11 to the connector 21. As described above, when the impedance of the load circuit 50 is the high impedance, the potential difference between the inverting input terminal 4a (-) and the non-inverting input terminal 4b (+) of the comparator 4 is smaller than the predetermined value, and the comparator 4 therefore does not operate, resulting in the state in which the comparator output terminal 4c of the comparator 4 is in the high level. Therefore, the emitter of the second transistor 2 is in the high level. Accordingly, the second transistor 2 is turned off. Since the second transistor 2 turns off, the base of the first transistor 1 is in the high level, and the first transistor 1 is also turned off. At that time, since the gate of the FET 3a is also in the high level, the FET 3a turns.on. The levels of the first output terminal 41 and the second output terminal 42 at that time are in the high level.

As a result, in the second mode in which the impedance of the load circuit 50 is the high impedance, the first transistor 1 turns off, causing the power not to be supplied from the power terminal 22 via the first transistor 1 to the load circuit 50.

Circuit operation states of the load-connection-state detection circuit 100 in the second mode will be described in the second mode in Fig. 3.

A circuit operation performed when the impedance of the load circuit 50 is the low impedance, that is, in a third mode, will be described. The state of the low impedance includes a state in which the connection state of the load circuit 50 is shorted out to the ground.

In the third mode, the power supply voltage Vcc is applied from the power terminal 22 via the second resistance 12 and the first resistance 11 to the connector 21, and a current flows through the load circuit 50. As described above, when the impedance of the load circuit 50 is the low impedance, the potential difference between the inverting input terminal 4a (-) and the non-inverting input terminal 4b (+) of the comparator 4 is larger than the predetermined value, resulting in the state in which the comparator output terminal 4c of the comparator 4 is in the low level. Therefore, the emitter of the second transistor 2 is in the low level. A voltage obtained by dividing the voltage by using the combined resistance of the second resistance 12 and the first resistance 11 and by using the impedance of the load circuit 50 is applied to the base of the second transistor 2. Since the impedance of the load circuit 50 is the low impedance, the voltage of the base of the second transistor 2 is not one which causes the second transistor 2 to turn on. In other words, when the impedance of the load circuit 50 is the low impedance, the thresholds for the impedances of the second resistance 12, the first resistance 11, and the load circuit 50 are determined so that the second transistor 2 is not turned on. Therefore, the second transistor 2 is turned off. Since the second transistor 2 turns off, the base of the first transistor 1 is in the high level, and the first transistor 1 is turned off. At that time, the gate of the FET 3a is in the high level, and the FET 3a therefore turns on. The level of the first output terminal 41 at that time is in the low level, and the level of the second output terminal 42 is in the high level.

Circuit operation states of the load-connection-state detection circuit 100 in the third mode are described in the third mode in Fig. 3.

As a result, in the third mode in which the impedance of the load circuit 50 is the low impedance, the first transistor 1 turns off, and the power is not supplied from the power terminal 22 via the first transistor 1 to the load circuit 50, whereby a current flows through the load circuit 50 via the first resistance 11. Therefore, when the impedance of the load circuit 50 is the low impedance, a large current does not flow through the semiconductor devices including the first transistor 1 even in the case where the load circuit 50 is shorted out to the ground, preventing the semiconductor devices from being damaged. Thus, the load-connection-state detection circuit 100 can limit a current.

States of the first output terminal 41 and the second output terminal 42 for transmitting the result obtained by detecting the connection state of the load circuit 50 to the outside are described in the table in Fig. 3. According to the table, when the impedance of the load circuit 50 is the appropriate impedance, the first output terminal 41 is in the low level, and the second output terminal 42 is also in the low level. When the impedance of the load circuit 50 is the high impedance, the first output terminal 41 is in the high level, and the second output terminal 42 is also in the high level. When the impedance of the load circuit 50 is the low impedance, the first output terminal 41 is in the low level, and the second output terminal 42 is in the high level. Therefore, in the first, second, and third modes, the combinations of the voltage level of the first output terminal 41 and that of the second output terminal 42 are different from each other. Therefore, by checking the voltage levels of the first output terminal 41 at which the output voltage of the comparator 4 appears and the second output terminal 42 at which the voltage of the collector of the second transistor 2 appears, the connection state of the load circuit 50 is easily detected.

For example, as illustrated in Fig. 1, the cable 56 and the amplifying circuit 52 serving as the load circuit 50 are connected to the load-connection-state detection circuit 100. Therefore, the load-connection-state detection circuit 100 can easily detect a state, such as the cutoff or short-circuit of the cable 56 or a failure of the amplifying circuit 52.

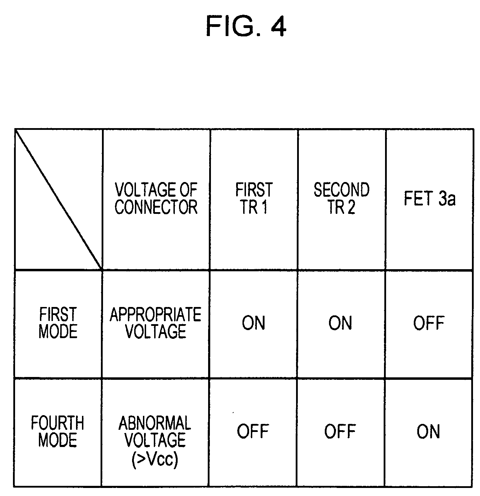

A circuit operation of the load-connection-state detection circuit 100 performed when an abnormal voltage is applied, such as when a voltage higher than the power supply voltage Vcc, for example, a voltage of a battery mounted in a vehicle, is accidentally applied from the outside in a state in which the load circuit 50 is not connected to the connector 21, will be described by using Figs. 2 and 4.

Before the description about when an abnormal voltage is applied, the state of the load-connection-state detection circuit 100 in a state in which the load circuit 50 in the appropriate impedance mode is connected to the connector 21 and in which the voltage of the connector 21 is an appropriate voltage will be described for comparison. This case is the same as the circuit operation at the time when the impedance of the load circuit 50 is the appropriate impedance, that is, in the first mode, as described above.

As illustrated in the first mode in the table in Fig. 4, as described above, the first transistor 1 turns on and the second transistor 2 also turns on in the first mode. Since the load circuit 50 has an appropriate impedance, an appropriate voltage is applied to the connector 21 via the second resistance 12 and the first transistor 1. At that time, since the voltage of the collector of the second transistor 2 is in the low level, the voltage of the gate of the FET 3a is also in the low level. Therefore, the FET 3a turns off. Accordingly, the FET 3a does not have an influence on the operation of the first transistor 1 and the second transistor 2.

A circuit operation of the load-connection-state detection circuit 100 at the time when an abnormal voltage is applied in the case where the load circuit 50 is not connected to the connector 21 and where a voltage higher than the power supply voltage Vcc is applied from the outside (fourth mode) will be described.

When a voltage higher than the power supply voltage Vcc, for example, a high voltage such as a battery voltage, is applied to the connector 21, a large voltage relative to the emitter of the second transistor 2 is applied to the base of the second transistor 2. Therefore, the second transistor 2 is turned on. At the same time, the high voltage applied to the connector 21 is applied to the emitter of the first transistor 1 via the first resistance 11, and appears at the base of the first transistor 1. As a result, the voltage is applied to the gate of the FET 3a. Accordingly, the voltage applied to the gate of the FET 3a becomes higher than the gate threshold voltage, the FET 3a is turned on, and the drain of the FET 3a is in the low level. As a result, the base of the second transistor 2 is in the low level, and the second transistor 2 is turned off. Therefore, the first transistor 1 is also turned off. After that, a current caused by the abnormal voltage applied to the connector 21 does not flow through the first transistor 1, and flows through the first resistance 11 connected between the emitter and the collector of the first transistor 1, enabling the current value to be suppressed. As a result, the semiconductor devices in the circuit can be protected. A current flowing through a regulator (not illustrated) connected between the vehicle battery (not illustrated) and the power terminal 22 is also reduced, enabling the semiconductor devices in the regulator to be protected.

Circuit operation states of the load-connection-state detection circuit 100 in the fourth mode are described in the fourth mode in Fig. 4.

As a result, in the case where a voltage higher than the power supply voltage Vcc is applied to the connector 21 from the outside, the first transistor 1 and the second transistor 2 are turned off, preventing a large current from flowing through the first transistor 1 and the second transistor 2 and preventing the semiconductor devices from being damaged.

As described above, the load-connection-state detection circuit 100 according to the embodiment of the present invention can limit a current and turn off the first transistor 1 and the second transistor 2 when an abnormal voltage higher than the power supply voltage Vcc is applied to the connector 21, by adding one element which is the switching element 3. As a result, a current caused by an abnormal voltage applied to the connector 21 flows through the first resistance 11 connected between the emitter and the collector of the first transistor 1, enabling the semiconductor devices in the circuit to be protected. Therefore, a load-connection-state detection circuit which protects the semiconductor devices in the circuit even when an abnormal voltage is applied to a connector can be achieved without increasing the circuit size.

The present invention is not limited to the description in the above-described embodiment, and can be implemented by changing the embodiment as appropriate in such a manner that the effect is achieved. For example, the load-connection-state detection circuit in the present invention includes components equivalent to those illustrated in Fig. 2. Other components may be included as long as the operation is not prevented from being performed. As a switching element, a bipolar transistor or the like may be used instead of a FET.

## Claims

1. A load-connection-state detection circuit (100) comprising:
a power terminal (22) that is supplied with power from the outside;
a connector (21) that supplies power to a load circuit (50) connected to the ground; and
a current limiting circuit (10),
wherein the current limiting circuit (10) includes a PNP first transistor (1) having an emitter coupled to the power terminal (22) and having a collector connected to the connector (21), an NPN second transistor (2) having an emitter coupled to the power terminal (22), having a collector coupled to a base of the first transistor (1), and having a base coupled to the collector of the first transistor (1), and a first resistance (11) connected between the emitter and the collector of the first transistor (1), in such a manner that a current flows via the first resistance (11) when a current is limited,
**characterized in that** the load-connection-state detection circuit (100) further includes a switching element (3) having a control end, one end of the switching element (3) is connected to the base of the second transistor (2), the other end of the switching element (3) is connected to the ground, and the control end is connected to the collector of the second transistor (2).

2. The load-connection-state detection circuit (100) according to Claim 1,
wherein the switching element (3) which is a field effect transistor (3a) has a drain connected to the base of the second transistor (2) and also has a source connected to the ground.

3. The load-connection-state detection circuit (100) according to Claim 1 or 2, further comprising:
a second resistance (12) having one end connected to the power terminal (22) and having the other end connected to the emitter of the first transistor (1); and
a comparator (4) having an output end, an inverting input terminal connected to one end of the second resistance (12) via a third resistance (13), and having a non-inverting input terminal connected to the other end of the second resistance (12) via a fourth resistance (14), wherein a fifth resistance (15) is connected between the inverting input terminal and the output end, and wherein the output end is connected to the emitter of the second transistor (2),
wherein a connection state of the load circuit (50) is detected from an output voltage from the comparator (4) and from a voltage of the collector of the second transistor (2).

4. The load-connection-state detection circuit (100) according to any one of Claims 1 to 3,
wherein the load circuit (50) includes a cable and an amplifying circuit.

## Patentansprüche

1. Lastverbindungszustands-Detektionsschaltung (100), aufweisend:
einen Leistungsanschluss (22), dem Energie von außen zugeführt wird;
einen Verbinder (21), der einer mit Masse verbundenen Lastschaltung (50) Energie zuführt; und
eine Strombegrenzungsschaltung (10),
wobei die Strombegrenzungsschaltung (10) einen ersten PNP-Transistor (1),
der mit dem Emitter mit dem Leistungsanschluss (22) gekoppelt ist und mit dem Kollektor mit dem Verbinder (21) verbunden ist, einen zweiten NPN-Transistor (2), der mit dem Emitter mit dem Leistungsanschluss (22) gekoppelt ist, mit dem Kollektor mit der Basis des ersten Transistors (1) gekoppelt ist und mit der Basis mit dem Kollektor des ersten Transistors (1) gekoppelt ist, sowie einen ersten Widerstand (11) aufweist, der derart zwischen den Emitter und den Kollektor des ersten Transistors (1) geschaltet ist, dass ein Strom über den ersten Widerstand (11) fließt, wenn ein Strom begrenzt wird,
**dadurch gekennzeichnet, dass** die Lastverbindungszustands-Detektionsschaltung (100) ferner ein Schaltelement (3) mit einem Steuerende aufweist,
wobei das eine Ende des Schaltelements (3) mit der Basis des zweiten Transistors (2) verbunden ist, das andere Ende des Schaltelements (3) mit Masse verbunden ist und das Steuerende mit dem Kollektor des zweiten Transistors (2) verbunden ist.

2. Lastverbindungszustands-Detektionsschaltung (100) nach Anspruch 1, wobei das Schaltelement (3), bei dem es sich um einen Feldeffekttransistor (3a) handelt, mit dem Drain mit der Basis des zweiten Transistors verbunden ist und mit der Source mit Masse verbunden ist.

3. Lastverbindungszustands-Detektionsschaltung (100) nach Anspruch 1 oder 2, weiterhin aufweisend:
einen zweiten Widerstand (12), der mit dem einen Ende mit dem Leistungsanschluss (22) verbunden ist und mit dem anderen Ende mit dem Emitter des ersten Transistors (1) verbunden ist; und
einen Komparator (4) mit einem Ausgangsende, mit einem invertierenden Eingangsanschluss, der über einen dritten Widerstand (13) mit dem einen Ende des zweiten Widerstands (12) verbunden ist, und mit einem nicht invertierenden Eingangsanschluss, der über einen vierten Widerstand (14) mit dem anderen Ende des zweiten Widerstands (12) verbunden ist, wobei ein fünfter Widerstand (15) zwischen den invertierenden Eingangsanschluss und das Ausgangsende geschaltet ist und wobei das Ausgangsende mit dem Emitter des zweiten Transistors (2) verbunden ist,
wobei ein Verbindungszustand der Lastschaltung (50) aus einer Ausgangsspannung von dem Komparator (4) und aus einer Spannung des Kollektors des zweiten Transistors (2) detektiert wird.

4. Lastverbindungszustands-Detektionsschaltung (100) nach einem der Ansprüche 1 bis 3,
wobei die Lastschaltung (50) ein Kabel und eine Verstärkerschaltung aufweist.

## Revendications

1. Circuit de détection d'état de connexion de charge (100) comprenant :
une borne électrique (22) qui est alimentée avec de l'électricité venant de l'extérieur ;
un connecteur (21) qui alimente en électricité un circuit de charge (50) connecté à la terre ; et
un circuit de limitation de courant (10),
dans lequel le circuit de limitation de courant (10) inclut un premier transistor PNP (1) ayant un émetteur couplé à la borne électrique (22) et ayant un collecteur connecté au connecteur (21), un second transistor NPN (2) ayant un émetteur couplé à la borne électrique (22), ayant un collecteur couplé à une base du premier transistor (1), et ayant une base couplée au collecteur du premier transistor (1), et une première résistance (11) connectée entre l'émetteur et le collecteur du premier transistor (1), de telle manière qu'un courant s'écoule via la première résistance (11) quand un courant est limité,
**caractérisé en ce que** le circuit de détection d'état de connexion de charge (100) inclut en outre un élément de commutation (3) comportant une extrémité de commande, une extrémité de l'élément de commutation (3) est connectée à la base du second transistor (2), l'autre extrémité de l'élément de commutation (3) est connectée à la terre, et l'extrémité de commande est connectée au collecteur du second transistor (2).

2. Circuit de détection d'état de connexion de charge (100) selon la revendication 1,
dans lequel l'élément de commutation (3) qui est un transistor à effet de champ (3a) a un drain connecté à la base du second transistor (2) et aussi une source connectée à la terre.

3. Circuit de détection d'état de connexion de charge (100) selon la revendication 1 ou 2, comprenant en outre :
une seconde résistance (12) ayant une extrémité connectée à la borne électrique (22) et ayant l'autre extrémité connecté à l'émetteur du premier transistor (1) ; et
un comparateur (4) ayant une extrémité de sortie, une borne d'entrée inverseuse connectée à une extrémité de la seconde résistance (12) via une troisième résistance (13), et ayant une borne d'entrée non-inverseuse connectée à l'autre extrémité de la seconde résistance (12) via une quatrième résistance (14), dans lequel une cinquième résistance (15) est connectée entre la borne d'entrée inverseuse et l'extrémité de sortie, et dans lequel l'extrémité de sortie est connectée à l'émetteur du second transistor (2),
dans lequel un état de connexion du circuit de charge (50) est détecté à partir d'une tension de sortie du comparateur (4) et d'une tension du collecteur du second transistor (2).

4. Circuit de détection d'état de connexion de charge (100) selon l'une quelconque des revendications 1 à 3,
dans lequel le circuit de charge (50) inclut un câble et un circuit amplificateur.
